# EUROPÄISCHE PATENTSCHRIFT

(11) **EP 2 859 985 B1**
(45) Veröffentlichungstag und Bekanntmachung des Hinweises auf die Patenterteilung: **28.12.2016**
(21) Anmeldenummer: 14188186.2
(22) Anmeldetag: 08.10.2014
(51) Int. Cl.: B23K 26/00, B28D 5/00, B23K 26/40, H01L 21/268, H01L 31/18

(54) **Waferherstellungsverfahren**
Wafer production method
Procédé de fabrication de tranches de silicium

(30) Priorität: 08.10.2013 DE 102013016666; 25.09.2014 DE 102014014486
(43) Veröffentlichungstag der Anmeldung: 15.04.2015
(60) Teilanmeldung: 16197742.6
(73) Patentinhaber: Siltectra GmbH, 01099 Dresden (DE)
(72) Erfinder: Richter, Jan, 01277 Dresden (DE)
(74) Vertreter: Ascherl, Andreas

(56) Entgegenhaltungen:
- WO-A2-2009/061353
- WO-A2-2013/126927
- US-A1- 2001 028 390
- US-A1- 2005 048 738
- US-A1- 2010 009 549
- US-A1- 2013 089 969
- BRUEL M ET AL: "Smart cut: a promising new SOI material technology", SOI CONFERENCE, 1995. PROCEEDINGS., 1995 IEEE INTERNATIONAL TUCSON, AZ, USA 3-5 OCT. 1995, NEW YORK, NY, USA,IEEE, US, 3. Oktober 1995 (1995-10-03), Seiten 178-179, XP010196531, DOI: 10.1109/SOI.1995.526518 ISBN: 978-0-7803-2547-0
- OHMURA ETSUJI ET AL: "Analysis of internal crack propagation in silicon due to permeable pulse laser irradiation: study on processing mechanism of stealth dicing", FUNDAMENTALS OF LASER-ASSISTED MICRO- AND NANOTECHNOLOGIES 2010, SPIE, 1000 20TH ST. BELLINGHAM WA 98225-6705 USA, Bd. 7996, Nr. 1, 22. Juli 2010 (2010-07-22), Seiten 1-8, XP060004916, DOI: 10.1117/12.887431 [gefunden am 2011-02-28]

## Beschreibung

Die vorliegende Erfindung bezieht sich auf Verfahren zum Herstellen von Festkörperschichten und/oder Festkörpern gemäß den Gegenständen der Ansprüche 1, 9 und 12 sowie auf jeweils mittels dieser Verfahren hergestellte Wafer oder Festkörper.

In vielen technischen Bereichen (z.B. Mikroelektronik- oder Photovoltaiktechnologie) werden Materialien, wie z.B. Silizium, Germanium oder Saphir, häufig in der Form dünner Scheiben und Platten (so genannte Wafer) gebraucht. Standardmäßig werden solche Wafer derzeit durch Sägen aus einem Ingot hergestellt, wobei relativ große Materialverluste ("kerf-loss") entstehen. Da das verwendete Ausgangsmaterial oft sehr teuer ist, gibt es starke Bestrebungen, solche Wafers mit weniger Materialaufwand und damit effizienter und kostengünstiger herzustellen.

Beispielsweise gehen mit den derzeit üblichen Verfahren allein bei der Herstellung von Siliziumwafern für Solarzellen fast 50% des eingesetzten Materials als "kerf-loss" verloren. Weltweit gesehen entspricht dies einem jährlichen Verlust von über 2 Milliarden Euro. Da die Kosten des Wafers den größten Anteil an den Kosten der fertigen Solarzelle ausmachen (über 40%), könnten durch entsprechende Verbesserungen der Waferherstellung die Kosten von Solarzellen signifikant reduziert werden.

Besonders attraktiv für eine solche Waferherstellung ohne kerf-loss ("kerf-free wafering") erscheinen Verfahren, die auf das herkömmliche Sägen verzichten und z.B. durch Einsatz von temperaturinduzierten Spannungen direkt dünne Wafer von einem dickeren Werkstück abspalten können. Dazu gehören insbesondere Verfahren, wie sie z.B. in PCT/US2008/012140 und PCT/EP2009/067539 beschrieben sind, wo zum Erzeugen dieser Spannungen eine auf das Werkstück aufgetragene Polymerschicht verwendet wird.

Die Polymerschicht weist bei den erwähnten Verfahren einen im Vergleich zum Werkstück um ungefähr zwei Größenordnungen höheren thermischen Ausdehnungskoeffizienten auf. Außerdem kann durch Ausnutzen eines Glasübergangs ein relativ hoher Elastizitätsmodul in der Polymerschicht erreicht werden, so dass im Schichtsystem Polymerschicht-Werkstück durch Abkühlen genügend große Spannungen induziert werden können, um die Abspaltung von Wafer vom Werkstück zu ermöglichen.

Beim Abspalten eines Wafers vom Werkstück haftet bei den erwähnten Verfahren jeweils auf einer Seite des Wafers noch Polymer an. Der Wafer krümmt sich dabei sehr stark in Richtung dieser Polymerschicht, was ein kontrolliertes Abspalten erschwert, und z.B. zu Dickenschwankungen des abgespaltenen Wafers führen kann. Außerdem erschwert die starke Krümmung die weitere Verarbeitung und kann sogar zum Zerbrechen des Wafers führen.

Bei Verwendung der Verfahren nach bisherigem Stand der Technik weisen die hergestellten Wafer üblicherweise jeweils größere Dickenschwankungen auf, wobei die räumliche Dickenverteilung häufig ein Muster mit vierzähliger Symmetrie zeigt. Die totale Dickenschwankung über den ganzen Wafer gesehen ("total thickness variation", TTV) beträgt bei Verwendung der bisherigen Verfahren häufig mehr als 100% der mittleren Waferdicke (ein Wafer von bspw. 100 Mikrometer mittlerer Dicke, der z.B. an seiner dünnsten Stelle 50 Mikrometer dick und an seiner dicksten Stelle 170 Mikrometer dick ist, hat ein TTV von 170-50=120 Mikrometer, was relativ zu seiner mittleren Dicke einer totalen Dickenschwankung von 120% entspricht). Wafer mit solch starken Dickenschwankungen sind für viele Anwendungen nicht geeignet. Außerdem liegen bei den am häufigsten auftretenden vierzähligen Dickenverteilungsmustern die Bereiche mit den größten Schwankungen unglücklicherweise in der Mitte des Wafers, wo sie am meisten stören. Außerdem entstehen beim Verfahren nach aktuellem Stand der Technik während der Bruchpropagation beim Abspalten selbst unerwünschte Oszillationen in den beteiligten Schichtsystemen, die den Verlauf der Bruchfront ungünstig beeinflussen und insbesondere zu signifikanten Dickenschwankungen des abgespaltenen Wafers führen können.

Zudem ist es bei den bisherigen Verfahren schwierig, einen reproduzierbar guten Wärmekontakt über die ganze Fläche der Polymerschicht sicherzustellen. Lokal ungenügender Wärmekontakt kann aber aufgrund der geringen thermischen Leitfähigkeit der verwendeten Polymere zu ungewollten, signifikanten lokalen Temperaturabweichungen im Schichtsystem führen, was sich seinerseits negativ auf die Kontrollierbarkeit der erzeugten Spannungsfelder und damit die Qualität der hergestellten Wafer auswirkt.

Weiterhin ist aus der Druckschrift DE 196 40 594 A1 ein Verfahren zur Trennung von Halbleitermaterialien mittels licht-induzierter Grenzflächenzersetzung und damit hergestellter Vorrichtungen, wie strukturierte und freistehende Halbleiterschichten und Bauelemente, bekannt. Das Verfahren gemäß der DE 196 40 594 A1 beinhaltet die Beleuchtung von Grenzflächen zwischen Substrat und Halbleiterschicht oder zwischen Halbleiterschichten, wodurch die Lichtabsorption an der Grenzfläche oder in einer dafür vorgesehenen Absorptionsschicht zur Materialzersetzung führt. Die Auswahl der Grenzfläche oder Halbleiterschicht, welche zur Zersetzung gebracht wird, erfolgt durch die Wahl der Lichtwellenlänge und Lichtintensität, die Einstrahlrichtung oder den Einbau einer dünnen Opferschicht während der Materialherstellung. Dieses Verfahren hat den Nachteil, dass zur Zerstörung ganzer Schichten hohe Energiedosen verwendet werden müssen, wodurch der Energiebedarf und somit die Kosten des Verfahrens sehr hoch sind.

WO 2013 / 126927 und US 2010/0009549 beschreiben beiden Prozesse, wobei ein Laser-Strahl innerhalb des Halbleitermaterials fokussierter wird und dort durch starke Aufheizung das Halbleitermaterial zersetzt. Mittels zweidimensionalen Rasterung des Laserstrahls wird eine "denaturierte" Ebene innerhalb des Substrats erzeugt, die eine leichte Abspaltung der oberen Schicht entlang der Defekt-Ebene ermöglicht.

Es ist somit die Aufgabe der vorliegenden Erfindung ein Verfahren zur Herstellung von Festkörperschichten oder Festkörpern bereitzustellen, das die kostengünstige Herstellung von Festkörperplatten oder unebenen Festkörpern mit einer gewünschten Dickenverteilung ermöglicht.

Die zuvor genannte Aufgabe wird erfindungsgemäß durch ein Verfahren zur Herstellung von Festkörperschichten, insbesondere zur Verwendung als Wafer, gelöst. Das erfindungsgemäße Verfahren umfasst dabei ein Verfahren gemäß dem Hauptanspruch 1.

Weitere bevorzugte Ausführungsformen sind nachfolgend genannt und/oder Gegenstand der Unteransprüche.

Gemäß einer bevorzugten Ausführungsform der vorliegenden Erfindung stimmten der Brechungsindex der Immersionsflüssigkeit und der Brechungsindex des Werkstücks zumindest im Wesentlichen überein und sind besonders bevorzugt identisch.

Die Immersionsflüssigkeit wird mit einer Abdeckplatte derart abgedeckt, dass zwischen der zu erzeugenden Rissführungsschicht und der Abdeckplatte bevorzugt stets derselbe Brechungsindex vorliegt, d.h. insbesondere keine Lufteinschlüsse zwischen der exponierten Oberfläche und der Abdeckplatte auftreten.

Die Abdeckplatte weist gemäß einer weiteren bevorzugten Ausführungsform der vorliegenden Erfindung zumindest auf der von der exponierten Oberfläche des Werkstücks abgewandten Seite eine Oberflächenrauheit auf, die geringer ist als die Oberflächenrauheit der exponierten Oberfläche.

Die Oberfläche der Abdeckplatte, die mit der Immersionsflüssigkeit in Kontakt ist, und die exponierte Oberfläche des Werkstücks gemäß einer weiteren bevorzugten Ausführungsform derart geneigt zueinander ausgerichtet sind, dass der Anteil der Immersionsflüssigkeit zwischen der Abdeckplatte und der exponierten Oberfläche in Abhängigkeit von Ort variiert. Bevorzugt ist der Raum zwischen der Abdeckplatte und der exponierten Oberfläche vollständig durch die Immersionsflüssigkeit gefüllt.

Diese Ausführungsform ist vorteilhaft, da mittels einer Defekterzeugungseinrichtung Defekte innerhalb des Werkstücks, insbesondere einem Ingot, derart erzeugt werden können, dass die erzeugte Festkörperschicht eine von einer ebenen Schicht abweichende Form, insbesondere die eines Spats, aufweisen kann.

Die Immersionsflüssigkeit wird gemäß einer weiteren bevorzugten Ausführungsform der vorliegenden Erfindung als Tropfen auf die exponierte Oberfläche aufgebracht und der Tropfen wird derart mit der Defekterzeugungsvorrichtung in Kontakt gebracht, dass eine Relativbewegung zwischen dem Werkstück und der Defekterzeugungsvorrichtung eine Umpositionierung des Tropfens bewirkt.

Gemäß einer weiteren bevorzugten Ausführungsform der vorliegenden Erfindung geben die Defekte mindestens eine Rissführungsschicht vor, wobei die mindestens eine Rissführungsschicht eine von einer ebenen Gestalt abweichende Gestalt aufweist. Diese Lösung ist vorteilhaft, da die erzeugten Festkörperschichten oder die erzeugten Festkörper eine von einer ebenen Schicht abweichende Gestalt aufweisen können. Es können somit nicht mehr nur ebene Schichten, sondern ebenfalls dreidimensionale Körper aus einem Werkstück mittels einer Rissausbreitung herausgebildet bzw. erzeugt werden. Derart hergestellte Festkörper weisen aufgrund des Herstellungsverfahrens eine sehr vorteilhafte und nur wenig bis nicht nachzubearbeitende Oberfläche auf. So sind z.B. optische Elemente, wie z.B. ein Spat oder eine Linse in einem einstufigen oder mehrstufigen, insbesondere zwei oder dreistufigen, Splitprozess herstellbar.

Die Gestalt der Rissführungsschicht weist somit gemäß einer bevorzugten Ausführungsform der vorliegenden Erfindung zumindest abschnittsweise die Kontur eines dreidimensionalen Objektes, insbesondere einer Linse oder eines Spaten, auf.

Die Defekte werden gemäß einer weiteren bevorzugten Ausführungsform der vorliegenden Erfindung in einer Rissführungsschicht erzeugt, wobei die Rissführungsschicht gegenüber der Längsachse des Werkstücks geneigt erzeugt wird und wobei die Rissführungsschicht und die Längsachse in einem Winkel zueinander ausgerichtet sind, der von 90° abweicht,

Gemäß einer bevorzugten Ausführungsform der vorliegenden Erfindung werden die Defekte mittels einer Defekterzeugungsvorrichtung erzeugt, wobei die Defekterzeugungsvorrichtung derart konfiguriert ist, dass die Defekte mit einem konstanten Abstand zur Defekterzeugungsvorrichtung in dem Werkstück erzeugt werden, wobei das Werkstück und die Defekterzeugungsvorrichtung derart relativ zueinander geneigt werden, dass die von der Defekterzeugungsvorrichtung erzeugten Defekte in der Rissführungsschicht erzeugt werden, wobei die Defekterzeugungsvorrichtung und das Werkstück während der Defekterzeugung lediglich zweidimensional zueinander umpositioniert werden. Die Defekterzeugungsvorrichtung wird somit bevorzugt gegenüber dem Werkstück umpositioniert oder das Werkstück wird gegenüber der Defekterzeugungsvorrichtung umpositioniert oder die Defekterzeugungsvorrichtung und das Werkstück werden beide zueinander umpositioniert.

Diese Ausführungsform ist vorteilhaft, da die Defekterzeugungseinrichtung zur Defekterzeugung lediglich umpositioniert werden muss und keine Modifikation der Defekterzeugungsvorrichtung bewirkt werden muss, insbesondere keine veränderte Defekteinbringtiefe bestimmt und eingestellt werden muss.

Die Defekte werden gemäß einer weiteren bevorzugten Ausführungsform mittels einer Defekterzeugungsvorrichtung erzeugt, wobei die Defekterzeugungsvorrichtung derart konfiguriert ist, dass die Defekte mit einem sich zeitweise veränderndem Abstand zur Defekterzeugungsvorrichtung in dem Werkstück erzeugt werden, wobei in Abhängigkeit von dem Abstand der Defekterzeugungsvorrichtung zu dem zu erzeugenden Defekts zumindest zeitweise eine Modifikation der Defekterzeugungsvorrichtung bewirkt wird, insbesondere eine veränderte Defekteinbringtiefe bestimmt und eingestellt wird. Diese Ausführungsform ist vorteilhaft, da bevorzugt keine Neigungsvorrichtung zum Neigen des Werkstücks vorgesehen werden muss.

Gemäß einer weiteren bevorzugten Ausführungsform der vorliegenden Erfindung wird die Defekterzeugungsvorrichtung in einer sich rechtwinklig zur Langsachse des Werkstücks erstreckenden Umpositionierebene umpositioniert und die Modifikation der Defekterzeugungsvorrichtung erfolgt derart in Abhängigkeit von der Position der Defekterzeugungsvorrichtung gegenüber dem Werkstück, dass Defekte in Abhängigkeit von der Position der Defekterzeugungsvorrichtung unterschiedlich weit von der Defekterzeugungsvorrichtung beabstandet erzeugt werden.

Die Rissführungsschicht ist gemäß einer weiteren bevorzugten Ausführungsform der vorliegenden Erfindung in einem Winkel zwischen 88° und 45° und bevorzugt zwischen 87° und 60° und besonders bevorzugt zwischen 86° und 80° gegenüber der Längsachse geneigt bzw. wird in einem solchen Winkel erzeugt.

Diese Ausführungsform ist vorteilhaft, da bei der Kristallzucht das Kristall (ein Ingot) nicht immer gleich genau in der gewünschten Richtung wächst, vielmehr hat die Kristallzucht Toleranzen im Gradbereich und einige Kristalle sind außerhalb der gewünschten Spezifikation. Durch die erfindungsgemäße Lösung lassen sich Rissführungsschichten bevorzugt erzeugen, wodurch trotz der bei der Kristallzucht auftretenden Probleme geeignete Festkörperschichten herstellbar sind, wodurch der Ausschuss signifikant verringert werden kann.

Gemäß einer weiteren bevorzugten Ausführungsform der vorliegenden Erfindung wird eine Defekterzeugungsvorrichtung, insbesondere eine Ionenkanone oder ein Laser, zum Erzeugen der Defekte verwendet wird.

Gemäß einer weiteren bevorzugten Ausführungsform der vorliegenden Erfindung werden Defekte innerhalb des Werkstücks zum Ausbilden von mindestens einer ersten Rissführungsschicht und einer zweiten Rissführungsschicht erzeugt, wobei eine Vielzahl der die erste Rissführungsschicht bildenden Defekte korrespondierende Defekt in der zweiten Rissführungsschicht aufweisen, wobei jeweils ein Defekte der ersten Rissführungsschicht und der jeweils mit dem Defekt der ersten Rissführungsschicht korrespondierende Defekt der zweiten Rissführungsschicht aus derselben Richtung erzeugt werden, bevorzugt wird durch die Rissausbreitung eine Festkörperschicht von dem Werkstück entlang der ersten Rissführungsschicht und/oder der zweiten Rissführungsschicht abgetrennt wird. Diese Lösung ist vorteilhaft, da bei einer Beaufschlagung von zwei, drei, vier oder mehr ebenen gleichzeitig bzw. unmittelbar nacheinander Fehler z.B. bei Verwendung eines Lasers durch den Lasereintritt in die Oberfläche minimiert, da nur die Differenz der beiden Fokuswerte wichtig ist und die Oberfläche diese Differenz nicht beeinflusst. Damit können (insbesondere sehr dünne) Wafer mit sehr genauem TTV und deutlich minimierten bow und warp erzeugt werden. Die beiden Rissführungsschichten, die bevorzugt als Ebenen erzeugt werden, können so ausgebildet werden, dass beim Absplitten erst eine Rissführungsschicht (z.B. die zweite Rissführungsschicht) und dann die andere bzw. eine weitere Rissführungsschicht (z.B. die erste Rissführungsschicht) splittet.

Gemäß einer bevorzugten Ausführungsform der vorliegenden Erfindung wird eine Defekterzeugungsvorrichtung, insbesondere eine Ionenkanone oder ein Laser, zum Erzeugen der Defekte verwendet, wobei die miteinander korrespondierenden Defekte der ersten Rissführungsschicht und der zweiten Rissführungsschicht jeweils nacheinander erzeugt werden.

Die Defekterzeugungsvorrichtung und die Oberfläche des Werkstücks werden gemäß einer weiteren bevorzugten Ausführungsform der vorliegenden Erfindung zum Erzeugen von mindestens zwei miteinander korrespondierenden Defekten relativ zueinander ausgerichtet.

Nach dem Erzeugen von mindestens zwei miteinander korrespondierenden Defekten werden die Defekterzeugungsvorrichtung und die Oberfläche des Werkstücks gemäß einer weiteren bevorzugten Ausführungsform der vorliegenden Erfindung derart neu relativ zueinander ausgerichtet, dass mindestens zwei weitere miteinander korrespondierende Defekte erzeugt werden.

Die Defekte der ersten Rissführungsschicht sind gemäß einer weiteren bevorzugten Ausführungsform der vorliegenden Erfindung weiter von der Oberfläche des Werkstücks beabstandet als die jeweils korrespondierenden Defekte der zweiten Rissführungsschicht, wobei von zwei miteinander korrespondierenden Defekten zunächst der die erste Rissführungsschicht mit ausbildende Defekt und danach der die zweite Rissführungsschicht mit ausbildende Defekt erzeugt wird.

Die erste Rissführungsschicht und/oder die zweite Rissführungsschicht weisen gemäß einer weiteren bevorzugten Ausführungsform der vorliegenden Erfindung die Gestalt einer Ebene auf oder weisen eine zumindest teilweise von einer ebenen Gestalt abweichende Gestalt, insbesondere teilweise die Gestalt eines Spats oder einer Linse, auf.

Der Festkörper bzw. das Werkstück weist bevorzugt ein Material oder eine Materialkombination aus einer der Hauptgruppen 3, 4 und 5 des Periodensystems der Elemente auf, wie z.B. Si, SiC, SiGe, Ge, GaAs, InP, GaN, Al2O3 (Saphir), AIN. Besonders bevorzugt weist der Festkörper eine Kombination aus in der dritten und fünften Gruppe des Periodensystems vorkommenden Elementen auf. Denkbare Materialien oder Materialkombinationen sind dabei z.B. Galliumarsenid, Silizium, Siliziumcarbid, etc. Weiterhin kann der Festkörper eine Keramik (z.B. Al2O3 - Alumiumoxid) aufweisen oder aus einer Keramik bestehen, bevorzugte Keramiken sind dabei z.B. Perovskitkeramiken (wie z.B. Pb-, O-, Ti/Zr-haltige Keramiken) im Allgemeinen und Blei-Magnesium-Niobate, Bariumtitanat, Lithiumtitanat, Yttrium-Aluminium-Granat, insbesondere Yttrium-Aluminium-Granat Kristalle für Festkörperlaseranwendungen, SAW-Keramiken (surface acoustic wave), wie z.B. Lithiumniobat, Galliumorthophosphat, Quartz, Calziumtitanat, etc. im Speziellen. Der Festkörper weist somit bevorzugt ein Halbleitermaterial oder ein Keramikmaterial auf bzw. besonders bevorzugt besteht der Festkörper aus mindestens einem Halbleitermaterial oder einem Keramikmaterial. Es ist weiterhin denkbar, dass der Festkörper ein transparentes Material aufweist oder teilweise aus einem transparenten Material, wie z.B. Saphir, besteht bzw. gefertigt ist. Weitere Materialien, die hierbei als Festkörpermaterial alleine oder in Kombination mit einem anderen Material in Frage kommen, sind z.B. "wide band gap"-Materialien, InAlSb, Hochtemperatursupraleiter, insbesondere seltene Erden Cuprate (z.B. YBa2Cu3O7). Es ist zusätzlich oder alternativ denkbar, dass der Festkörper eine Photomaske ist, wobei als Photomaskenmaterial im vorliegenden Fall bevorzugt jedes zum Anmeldetag bekannte Photomaskenmaterial und besonders bevorzugt Kombinationen daraus verwendet werden können.

Die Erfindung bezieht sich ferner auf einen Wafer oder auf einen unebenen Festkörper, der nach einem Verfahren gemäß einem der Ansprüche 1 bis 7 hergestellt wird.

Gemäß einer bevorzugten Ausführungsform werden Defekten mittels mindestens einer Defekterzeugungsvorrichtung, insbesondere einem Laser, in der inneren Struktur des Werkstücks zum Vorgeben einer Rissführungsschicht, entlang der die Festkörperschicht oder der Festkörper vom Werkstück abgetrennt wird, erzeugt, wobei die Defekte derart voneinander beabstandet erzeugt werden, dass eine bei der jeweiligen Defekterzeugung lokale erfolgende Erhitzung des Werkstück von weiteren bei der Erzeugung weiterer Defekt erfolgender Erhitzungen des Werkstücks entkoppelt ist, wobei bevorzugt jede bei der jeweiligen Defekterzeugung lokale erfolgende Erhitzung des Werkstück von den weiteren bei der Erzeugung weiterer Defekt erfolgender Erhitzungen des Werkstücks entkoppelt ist.

Diese Ausführungsform ist vorteilhaft, da die einzelnen lokalen Erhitzungen ungehindert abkühlen können und sich nicht durch nebeneinander erzeugte Defekte eine zusätzlich Erhitzung eines Teils des Werkstücks bewirkt wird, wodurch die Erzeugung hoher lokaler Spannungen verhindert wird.

Gemäß einer bevorzugten Ausführungsform der vorliegenden Erfindung werden die Defekte nach einem vorgegebenen Muster erzeugt.

Gemäß einer bevorzugten Ausführungsform der vorliegenden Erfindung wird die Reihenfolge der Defekte von einem Algorithmus erzeugt.

Ferner besitzen Wafer für die weitere Verwendung als sogenannte EPI-Wafer (Wafer auf denen eine Epitaxie mit einem weiteren Material erfolgen soll) typischerweise eine geneigte Kristallebene. Diese geneigte Kristallebene erleichtert das gerichtete Aufwachsen der EPI-Schicht. Dabei ist Stand der Technik, dass es keine einheitliche Neigung der Kristallebene für die verschiedenen EPI-Verfahren gibt. Vielmehr hat jeder Hersteller von EPI-Schichten seine bevorzugte Neigung. Für die Herstellung von Wafer für das EPI-Verfahren ergibt sich somit das Problem, keine einheitliche Verkippung der Kristallebene anbieten zu können, sondern auf eine Vielzahl von Kundenwünschen eingehen zu müssen.

Es ist somit gemäß einem weiteren Aspekt der Erfindung ferner die Aufgabe ein Verfahren zur Herstellung von Festkörperschichten und/oder unebenen Festkörpern bereitzustellen, das die kostengünstige Herstellung von Festkörperplatten bzw. Wafern, insbesondere mit einer gewünschten Dickenverteilung ermöglicht, z.B. mit einem TTV von weniger als 120 Mikrometer, oder unebenen Festkörper mit vorgegebenen Konturen ermöglicht.

Die zuvor genannte Aufgabe wird erfindungsgemäß durch ein Verfahren zur Herstellung von Festkörperschichten, insbesondere zur Verwendung als Wafer, gelöst. Das erfindungsgemäße Verfahren umfasst dabei bevorzugt die folgenden Schritte:
Bereitstellen eines Werkstücks zum Ablösen der Festkörperschichten und/oder unebenen Festkörpern, wobei die die Festkörperschichten oder unebenen Festkörper bildenden Materialanteile des Werkstücks vor dem Ablösen in Längsrichtung des Werkstücks übereinander angeordnet sind, und wobei das Werkstück zumindest eine exponierte Oberfläche aufweist, Erzeugen von Defekten innerhalb des Werkstücks, wobei die Defekte in einer Rissführungsschicht erzeugt werden, wobei die Rissführungsschicht gegenüber der Längsachse des Werkstücks geneigt erzeugt wird, wobei die Rissführungsschicht und die Längsachse in einem Winkel zueinander ausgerichtet sind, der von 90° abweicht, Anbringung oder Erzeugung einer Aufnahmeschicht an der exponierten Oberfläche des Werkstücks unter Bildung einer Kompositstruktur, Temperieren der Aufnahmeschicht zum Erzeugen von Spannungen innerhalb des Werkstücks, wobei die Spannungen eine Rissausbreitung innerhalb des Werkstücks bewirken, wobei durch die Rissausbreitung eine Festkörperschicht oder ein unebener Festkörper von dem Werkstück entlang der Rissführungsschicht abgetrennt wird. Diese Lösung ist vorteilhaft, da durch das erfindungsgemäße Verfahren die Herstellung von Wafern selbst für Kleinserien oder einzelne Wafer erleichtert wird, da die Verkippung zur Kristallachse bzw. zur Festkörperlängsachse sehr genau bzw. exakt (im Sinne der Definition der Laserebene) dem Kundenwunsch entsprechend eingestellt werden kann.

Weitere bevorzugte Ausführungsformen sind nachfolgend genannt und/oder Gegenstand der Unteransprüche.

Gemäß einer bevorzugten Ausführungsform der vorliegenden Erfindung werden die Defekte mittels einer Defekterzeugungsvorrichtung erzeugt, wobei die Defekterzeugungsvorrichtung derart konfiguriert ist, dass die Defekte mit einem konstanten Abstand zur Defekterzeugungsvorrichtung in dem Werkstück erzeugt werden, wobei das Werkstück und die Defekterzeugungsvorrichtung derart relativ zueinander geneigt werden, dass die von der Defekterzeugungsvorrichtung erzeugten Defekte in der Rissführungsschicht erzeugt werden, wobei die Defekterzeugungsvorrichtung und das Werkstück während der Defekterzeugung lediglich zweidimensional zueinander umpositioniert werden. Die Defekterzeugungsvorrichtung wird somit bevorzugt gegenüber dem Werkstück umpositioniert oder das Werkstück wird gegenüber der Defekterzeugungsvorrichtung umpositioniert oder die Defekterzeugungsvorrichtung und das Werkstück werden beide zueinander umpositioniert.

Diese Ausführungsform ist vorteilhaft, da die Defekterzeugungseinrichtung zur Defekterzeugung lediglich umpositioniert werden muss und keine Modifikation der Defekterzeugungsvorrichtung bewirkt werden muss, insbesondere keine veränderte Defekteinbringtiefe bestimmt und eingestellt werden muss.

Die Defekte werden gemäß einer weiteren bevorzugten Ausführungsform mittels einer Defekterzeugungsvorrichtung erzeugt, wobei die Defekterzeugungsvorrichtung derart konfiguriert ist, dass die Defekte mit einem sich zeitweise veränderndem Abstand zur Defekterzeugungsvorrichtung in dem Werkstück erzeugt werden, wobei in Abhängigkeit von dem Abstand der Defekterzeugungsvorrichtung zu dem zu erzeugenden Defekts zumindest zeitweise eine Modifikation der Defekterzeugungsvorrichtung bewirkt wird, insbesondere eine veränderte Defekteinbringtiefe bestimmt und eingestellt wird. Diese Ausführungsform ist vorteilhaft, da bevorzugt keine Neigungsvorrichtung zum Neigen des Werkstücks vorgesehen werden muss.

Gemäß einer weiteren bevorzugten Ausführungsform der vorliegenden Erfindung wird die Defekterzeugungsvorrichtung in einer sich rechtwinklig zur Langsachse des Werkstücks erstreckenden Umpositionierebene umpositioniert und die Modifikation der Defekterzeugungsvorrichtung erfolgt derart in Abhängigkeit von der Position der Defekterzeugungsvorrichtung gegenüber dem Werkstück, dass Defekte in Abhängigkeit von der Position der Defekterzeugungsvorrichtung unterschiedlich weit von der Defekterzeugungsvorrichtung beabstandet erzeugt werden.

Die Rissführungsschicht ist gemäß einer weiteren bevorzugten Ausführungsform der vorliegenden Erfindung in einem Winkel zwischen 88° und 45° und bevorzugt zwischen 87° und 60° und besonders bevorzugt zwischen 86° und 80° gegenüber der Längsachse geneigt.

Diese Ausführungsform ist vorteilhaft, da bei der Kristallzucht das Kristall (ein Ingot) nicht immer gleich genau in der gewünschten Richtung wächst, vielmehr hat die Kristallzucht Toleranzen im Gradbereich und einige Kristalle sind außerhalb der gewünschten Spezifikation. Durch die erfindungsgemäße Lösung lassen sich Rissführungsschichten bevorzugt erzeugen, wodurch trotz der bei der Kristallzucht auftretenden Probleme geeignete Festkörperschichten herstellbar sind, wodurch der Ausschuss signifikant verringert werden kann.

Vor der Erzeugung der Defekte wird eine Immersionsflüssigkeit auf die exponierte Oberfläche aufgebracht und zur Erzeugung der Defekte erfolgt eine Beaufschlagung des Werkstücks durch die Immersionsflüssigkeit hindurch. Gemäß einer bevorzugten Ausführungsform der vorliegenden Erfindung stimmt der Brechungsindex der Immersionsflüssigkeit bevorzugt mit dem Brechungsindex des Werkstücks zumindest im Wesentlichen überein.

Die Immersionsflüssigkeit wird in einer solchen Menge auf der exponierten Oberfläche aufgebracht, dass durch sie zumindest mehr als die Hälfte und bevorzugt vollständig die exponierte Oberfläche benetzt wird oder die Immersionsflüssigkeit wird mit einer Abdeckplatte derart abgedeckt, dass zwischen der zu erzeugenden Rissführungsschicht und der Abdeckplatte derselbe Brechungsindex vorliegt, insbesondere keine Lufteinschlüsse zwischen der exponierten Oberfläche und der Abdeckplatte auftreten.

Gemäß einer weiteren bevorzugten Ausführungsform der vorliegenden Erfindung weist die Abdeckplatte zumindest auf der von der exponierten Oberfläche des Werkstücks abgewandten Seite eine Oberflächenrauheit auf, die geringer ist als die Oberflächenrauheit der exponierten Oberfläche.

Gemäß einer weiteren bevorzugten Ausführungsform der vorliegenden Erfindung geben die Defekte mindestens eine Rissführungsschicht vor, wobei die mindestens eine Rissführungsschicht eine von einer ebenen Gestalt abweichende Gestalt aufweist. Diese Lösung ist vorteilhaft, da die erzeugten Festkörperschichten oder die erzeugten Festkörper eine von einer ebenen Schicht abweichende Gestalt aufweisen können. Es können somit nicht mehr nur ebene Schichten, sondern ebenfalls dreidimensionale Körper aus einem Werkstück mittels einer Rissausbreitung herausgebildet bzw. erzeugt werden. Derart hergestellte Festkörper weisen aufgrund des Herstellungsverfahrens eine sehr vorteilhafte und nur wenig bis nicht nachzubearbeitende Oberfläche auf. So sind z.B. optische Elemente, wie z.B. ein Spat oder eine Linse in einem einstufigen oder mehrstufigen, insbesondere zwei oder dreistufigen, Splitprozess herstellbar.

Die Gestalt der Rissführungsschicht weist somit gemäß einer bevorzugten Ausführungsform der vorliegenden Erfindung zumindest abschnittsweise die Kontur eines dreidimensionalen Objektes, insbesondere einer Linse oder eines Spaten, auf.

Gemäß einer weiteren bevorzugten Ausführungsform der vorliegenden Erfindung wird eine Defekterzeugungsvorrichtung, insbesondere eine Ionenkanone oder ein Laser, zum Erzeugen der Defekte verwendet wird.

Gemäß einer weiteren bevorzugten Ausführungsform der vorliegenden Erfindung werden Defekte innerhalb des Werkstücks zum Ausbilden von mindestens einer ersten Rissführungsschicht und einer zweiten Rissführungsschicht erzeugt, wobei eine Vielzahl der die erste Rissführungsschicht bildenden Defekte korrespondierende Defekt in der zweiten Rissführungsschicht aufweisen, wobei jeweils ein Defekte der ersten Rissführungsschicht und der jeweils mit dem Defekt der ersten Rissführungsschicht korrespondierende Defekt der zweiten Rissführungsschicht aus derselben Richtung erzeugt werden, bevorzugt wird durch die Rissausbreitung eine Festkörperschicht von dem Werkstück entlang der ersten Rissführungsschicht und/oder der zweiten Rissführungsschicht abgetrennt wird. Diese Lösung ist vorteilhaft, da bei einer Beaufschlagung von zwei, drei, vier oder mehr ebenen gleichzeitig bzw. unmittelbar nacheinander Fehler z.B. bei Verwendung eines Lasers durch den Lasereintritt in die Oberfläche minimiert, da nur die Differenz der beiden Fokuswerte wichtig ist und die Oberfläche diese Differenz nicht beeinflusst. Damit können (insbesondere sehr dünne) Wafer mit sehr genauem TTV und deutlich minimierten bow und warp erzeugt werden. Die beiden Rissführungsschichten, die bevorzugt als Ebenen erzeugt werden, können so ausgebildet werden, dass beim Absplitten erst eine Rissführungsschicht (z.B. die zweite Rissführungsschicht) und dann die andere bzw. eine weitere Rissführungsschicht (z.B. die erste Rissführungsschicht) splittet.

Gemäß einer bevorzugten Ausführungsform der vorliegenden Erfindung wird eine Defekterzeugungsvorrichtung, insbesondere eine Ionenkanone oder ein Laser, zum Erzeugen der Defekte verwendet, wobei die miteinander korrespondierenden Defekte der ersten Rissführungsschicht und der zweiten Rissführungsschicht jeweils nacheinander erzeugt werden.

Die Defekterzeugungsvorrichtung und die Oberfläche des Werkstücks werden gemäß einer weiteren bevorzugten Ausführungsform der vorliegenden Erfindung zum Erzeugen von mindestens zwei miteinander korrespondierenden Defekten relativ zueinander ausgerichtet. Nach dem Erzeugen von mindestens zwei miteinander korrespondierenden Defekten werden die Defekterzeugungsvorrichtung und die Oberfläche des Werkstücks gemäß einer weiteren bevorzugten Ausführungsform der vorliegenden Erfindung derart neu relativ zueinander ausgerichtet, dass mindestens zwei weitere miteinander korrespondierende Defekte erzeugt werden.

Die Defekte der ersten Rissführungsschicht sind gemäß einer weiteren bevorzugten Ausführungsform der vorliegenden Erfindung weiter von der Oberfläche des Werkstücks beabstandet als die jeweils korrespondierenden Defekte der zweiten Rissführungsschicht, wobei von zwei miteinander korrespondierenden Defekten zunächst der die erste Rissführungsschicht mit ausbildende Defekt und danach der die zweite Rissführungsschicht mit ausbildende Defekt erzeugt wird.

Die erste Rissführungsschicht und/oder die zweite Rissführungsschicht weisen gemäß einer weiteren bevorzugten Ausführungsform der vorliegenden Erfindung die Gestalt einer Ebene auf oder weisen eine zumindest teilweise von einer ebenen Gestalt abweichende Gestalt, insbesondere teilweise die Gestalt eines Spats oder einer Linse, auf.

Der Festkörper bzw. das Werkstück weist bevorzugt ein Material oder eine Materialkombination aus einer der Hauptgruppen 3, 4 und 5 des Periodensystems der Elemente auf, wie z.B. Si, SiC, SiGe, Ge, GaAs, InP, GaN, Al2O3 (Saphir), AIN. Besonders bevorzugt weist der Festkörper eine Kombination aus in der dritten und fünften Gruppe des Periodensystems vorkommenden Elementen auf. Denkbare Materialien oder Materialkombinationen sind dabei z.B. Galliumarsenid, Silizium, Siliziumcarbid, etc. Weiterhin kann der Festkörper eine Keramik (z.B. Al2O3 - Alumiumoxid) aufweisen oder aus einer Keramik bestehen, bevorzugte Keramiken sind dabei z.B. Perovskitkeramiken (wie z.B. Pb-, O-, Ti/Zr-haltige Keramiken) im Allgemeinen und Blei-Magnesium-Niobate, Bariumtitanat, Lithiumtitanat, Yttrium-Aluminium-Granat, insbesondere Yttrium-Aluminium-Granat Kristalle für Festkörperlaseranwendungen, SAW-Keramiken (surface acoustic wave), wie z.B. Lithiumniobat, Galliumorthophosphat, Quartz, Calziumtitanat, etc. im Speziellen. Der Festkörper weist somit bevorzugt ein Halbleitermaterial oder ein Keramikmaterial auf bzw. besonders bevorzugt besteht der Festkörper aus mindestens einem Halbleitermaterial oder einem Keramikmaterial. Es ist weiterhin denkbar, dass der Festkörper ein transparentes Material aufweist oder teilweise aus einem transparenten Material, wie z.B. Saphir, besteht bzw. gefertigt ist. Weitere Materialien, die hierbei als Festkörpermaterial alleine oder in Kombination mit einem anderen Material in Frage kommen, sind z.B. "wide band gap"-Materialien, InAlSb, Hochtemperatursupraleiter, insbesondere seltene Erden Cuprate (z.B. YBa2Cu3O7). Es ist zusätzlich oder alternativ denkbar, dass der Festkörper eine Photomaske ist, wobei als Photomaskenmaterial im vorliegenden Fall bevorzugt jedes zum Anmeldetag bekannte Photomaskenmaterial und besonders bevorzugt Kombinationen daraus verwendet werden können.

Gemäß einer bevorzugten Ausführungsform werden Defekten mittels mindestens einer Defekterzeugungsvorrichtung, insbesondere einem Laser, in der inneren Struktur des Werkstücks zum Vorgeben einer Rissführungsschicht, entlang der die Festkörperschicht oder der Festkörper vom Werkstück abgetrennt wird, erzeugt, wobei die Defekte derart voneinander beabstandet erzeugt werden, dass eine bei der jeweiligen Defekterzeugung lokale erfolgende Erhitzung des Werkstück von weiteren bei der Erzeugung weiterer Defekt erfolgender Erhitzungen des Werkstücks entkoppelt ist, wobei bevorzugt jede bei der jeweiligen Defekterzeugung lokale erfolgende Erhitzung des Werkstück von den weiteren bei der Erzeugung weiterer Defekt erfolgender Erhitzungen des Werkstücks entkoppelt ist. Diese Ausführungsform ist vorteilhaft, da die einzelnen lokalen Erhitzungen ungehindert abkühlen können und sich nicht durch nebeneinander erzeugte Defekte eine zusätzlich Erhitzung eines Teils des Werkstücks bewirkt wird, wodurch die Erzeugung hoher lokaler Spannungen verhindert wird.

Gemäß einer bevorzugten Ausführungsform der vorliegenden Erfindung werden die Defekte nach einem vorgegebenen Muster erzeugt.

Gemäß einer bevorzugten Ausführungsform der vorliegenden Erfindung wird die Reihenfolge der Defekte von einem Algorithmus erzeugt.

Es ist gemäß einem Beispiel, das nicht unter dem Schutzbereich der Ansprüche fällt Aufgabe ein Verfahren zur Herstellung von Festkörperschichten oder unebenen Festkörpern bereitzustellen, das die kostengünstige Herstellung von Festkörperplatten bzw. Wafern oder unebenen Festkörpern ermöglicht.

Die zuvor genannte Aufgabe wird durch ein Verfahren zur Herstellung von Festkörperschichten, insbesondere zur Verwendung als Wafer, und/oder unebenen Festkörpern gelöst. Das Verfahren umfasst dabei bevorzugt die folgenden Schritte:
Bereitstellen eines Werkstücks zum Ablösen der mindestens einen Festkörperschicht und/oder des mindestens einen unebenen Festkörpers, wobei die die Festkörperschichten und/oder Festkörper bildenden Materialanteile des Werkstücks vor dem Ablösen in Längsrichtung des Werkstücks übereinander angeordnet sind, und wobei das Werkstück zumindest eine exponierte Oberfläche aufweist, Erzeugen von Defekten innerhalb des Werkstücks zum Ausbilden von mindestens einer ersten Rissführungsschicht und einer zweiten Rissführungsschicht, wobei eine Vielzahl der die erste Rissführungsschicht bildenden Defekte korrespondierende Defekt in der zweiten Rissführungsschicht aufweisen, wobei jeweils ein Defekte der ersten Rissführungsschicht und der jeweils mit dem Defekt der ersten Rissführungsschicht korrespondierende Defekt der zweiten Rissführungsschicht aus derselben Richtung erzeugt werden Anbringung oder Erzeugung einer Aufnahmeschicht an der exponierten Oberfläche des Werkstücks unter Bildung einer Kompositstruktur, Temperieren der Aufnahmeschicht zum Erzeugen von Spannungen innerhalb des Werkstücks, wobei die Spannungen eine Rissausbreitung innerhalb des Werkstücks bewirken, wobei durch die Rissausbreitung eine Festkörperschicht oder ein Festkörper von dem Werkstück entlang der ersten Rissführungsschicht und/oder der zweiten Rissführungsschicht abgetrennt wird.

Diese Lösung ist vorteilhaft, da bei einer Beaufschlagung von zwei, drei, vier oder mehr ebenen gleichzeitig bzw. unmittelbar nacheinander Fehler z.B. bei Verwendung eines Lasers durch den Lasereintritt in die Oberfläche minimiert, da nur die Differenz der beiden Fokuswerte wichtig ist und die Oberfläche diese Differenz nicht beeinflusst. Damit können (insbesondere sehr dünne) Wafer mit sehr genauem TTV und deutlich minimierten bow und warp erzeugt werden. Die beiden Rissführungsschichten, die bevorzugt als Ebenen erzeugt werden, können so ausgebildet werden, dass beim Absplitten erst eine Rissführungsschicht (z.B. die zweite Rissführungsschicht) und dann die andere bzw. eine weitere Rissführungsschicht (z.B. die erste Rissführungsschicht) splittet.

Weitere bevorzugte Ausführungsformen sind nachfolgend genannt und/oder Gegenstand der Unteransprüche.

Gemäß einer bevorzugten Ausführungsform der vorliegenden Erfindung wird eine Defekterzeugungsvorrichtung, insbesondere eine Ionenkanone oder ein Laser, insbesondere ein Neodym-dotierter Yttrium-Aluminium-Granat-Laser, zum Erzeugen der Defekte verwendet, wobei die miteinander korrespondierenden Defekte der ersten Rissführungsschicht und der zweiten Rissführungsschicht jeweils bevorzugt unmittelbar nacheinander erzeugt werden.

Die Defekterzeugungsvorrichtung und die Oberfläche des Werkstücks werden gemäß einer weiteren bevorzugten Ausführungsform der vorliegenden Erfindung zum Erzeugen von mindestens zwei miteinander korrespondierenden Defekten relativ zueinander ausgerichtet.

Nach dem Erzeugen von mindestens zwei miteinander korrespondierenden Defekten werden die Defekterzeugungsvorrichtung und die Oberfläche des Werkstücks gemäß einer weiteren bevorzugten Ausführungsform der vorliegenden Erfindung derart neu relativ zueinander ausgerichtet, dass mindestens zwei weitere miteinander korrespondierende Defekte erzeugt werden.

Die Defekte der ersten Rissführungsschicht sind gemäß einer weiteren bevorzugten Ausführungsform der vorliegenden Erfindung weiter von der Oberfläche des Werkstücks beabstandet als die jeweils korrespondierenden Defekte der zweiten Rissführungsschicht, wobei von zwei miteinander korrespondierenden Defekten zunächst der die erste Rissführungsschicht mit ausbildende Defekt und danach der die zweite Rissführungsschicht mit ausbildende Defekt erzeugt wird.

Die erste Rissführungsschicht und/oder die zweite Rissführungsschicht weisen gemäß einer weiteren bevorzugten Ausführungsform der vorliegenden Erfindung die Gestalt einer Ebene auf oder weisen eine zumindest teilweise von einer ebenen Gestalt abweichende Gestalt, insbesondere teilweise die Gestalt eines Spats oder einer Linse, auf.

Die Defekte werden gemäß einer weiteren bevorzugten Ausführungsform der vorliegenden Erfindung in einer Rissführungsschicht erzeugt, wobei die Rissführungsschicht gegenüber der Längsachse des Werkstücks geneigt erzeugt wird und wobei die Rissführungsschicht und die Längsachse in einem Winkel zueinander ausgerichtet sind, der von 90° abweicht,

Gemäß einer bevorzugten Ausführungsform der vorliegenden Erfindung werden die Defekte mittels einer Defekterzeugungsvorrichtung erzeugt, wobei die Defekterzeugungsvorrichtung derart konfiguriert ist, dass die Defekte mit einem konstanten Abstand zur Defekterzeugungsvorrichtung in dem Werkstück erzeugt werden, wobei das Werkstück und die Defekterzeugungsvorrichtung derart relativ zueinander geneigt werden, dass die von der Defekterzeugungsvorrichtung erzeugten Defekte in der Rissführungsschicht erzeugt werden, wobei die Defekterzeugungsvorrichtung und das Werkstück während der Defekterzeugung lediglich zweidimensional zueinander umpositioniert werden. Die Defekterzeugungsvorrichtung wird somit bevorzugt gegenüber dem Werkstück umpositioniert oder das Werkstück wird gegenüber der Defekterzeugungsvorrichtung umpositioniert oder die Defekterzeugungsvorrichtung und das Werkstück werden beide zueinander umpositioniert.

Diese Ausführungsform ist vorteilhaft, da die Defekterzeugungseinrichtung zur Defekterzeugung lediglich umpositioniert werden muss und keine Modifikation der Defekterzeugungsvorrichtung bewirkt werden muss, insbesondere keine veränderte Defekteinbringtiefe bestimmt und eingestellt werden muss.

Die Defekte werden gemäß einer weiteren bevorzugten Ausführungsform mittels einer Defekterzeugungsvorrichtung erzeugt, wobei die Defekterzeugungsvorrichtung derart konfiguriert ist, dass die Defekte mit einem sich zeitweise veränderndem Abstand zur Defekterzeugungsvorrichtung in dem Werkstück erzeugt werden, wobei in Abhängigkeit von dem Abstand der Defekterzeugungsvorrichtung zu dem zu erzeugenden Defekts zumindest zeitweise eine Modifikation der Defekterzeugungsvorrichtung bewirkt wird, insbesondere eine veränderte Defekteinbringtiefe bestimmt und eingestellt wird. Diese Ausführungsform ist vorteilhaft, da bevorzugt keine Neigungsvorrichtung zum Neigen des Werkstücks vorgesehen werden muss.

Gemäß einer weiteren bevorzugten Ausführungsform der vorliegenden Erfindung wird die Defekterzeugungsvorrichtung in einer sich rechtwinklig zur Langsachse des Werkstücks erstreckenden Umpositionierebene umpositioniert und die Modifikation der Defekterzeugungsvorrichtung erfolgt derart in Abhängigkeit von der Position der Defekterzeugungsvorrichtung gegenüber dem Werkstück, dass Defekte in Abhängigkeit von der Position der Defekterzeugungsvorrichtung unterschiedlich weit von der Defekterzeugungsvorrichtung beabstandet erzeugt werden.

Die Rissführungsschicht ist gemäß einer weiteren bevorzugten Ausführungsform der vorliegenden Erfindung in einem Winkel zwischen 88° und 45° und bevorzugt zwischen 87° und 60° und besonders bevorzugt zwischen 86° und 80° gegenüber der Längsachse geneigt. Diese Ausführungsform ist vorteilhaft, da bei der Kristallzucht das Kristall (ein Ingot) nicht immer gleich genau in der gewünschten Richtung wächst, vielmehr hat die Kristallzucht Toleranzen im Gradbereich und einige Kristalle sind außerhalb der gewünschten Spezifikation. Durch die erfindungsgemäße Lösung lassen sich Rissführungsschichten bevorzugt erzeugen, wodurch trotz der bei der Kristallzucht auftretenden Probleme geeignete Festkörperschichten herstellbar sind, wodurch der Ausschuss signifikant verringert werden kann.

Vor der Erzeugung der Defekte wird gemäß einer weiteren bevorzugten Ausführungsform der vorliegenden Erfindung eine Immersionsflüssigkeit auf die exponierte Oberfläche aufgebracht und zur Erzeugung der Defekte erfolgt eine Beaufschlagung des Werkstücks durch die Immersionsflüssigkeit hindurch. Gemäß einer weiteren bevorzugten Ausführungsform der vorliegenden Erfindung stimmt der Brechungsindex der Immersionsflüssigkeit bevorzugt mit dem Brechungsindex des Werkstücks zumindest im Wesentlichen überein.

Gemäß der vorliegenden Erfindung wird die Immersionsflüssigkeit in einer solchen Menge auf der exponierten Oberfläche aufgebracht, dass durch sie zumindest mehr als die Hälfte und bevorzugt vollständig die exponierte Oberfläche benetzt wird
Gemäß der vorliegenden Erfindung wird die Immersionsflüssigkeit mit einer Abdeckplatte derart abgedeckt, dass zwischen der zu erzeugenden Rissführungsschicht und der Abdeckplatte derselbe Brechungsindex vorliegt, insbesondere keine Lufteinschlüsse zwischen der exponierten Oberfläche und der Abdeckplatte auftreten.

Gemäß einer weiteren bevorzugten Ausführungsform der vorliegenden Erfindung weist die Abdeckplatte zumindest auf der von der exponierten Oberfläche des Werkstücks abgewandten Seite eine Oberflächenrauheit auf, die geringer ist als die Oberflächenrauheit der exponierten Oberfläche.

Gemäß einer weiteren bevorzugten Ausführungsform der vorliegenden Erfindung geben die Defekte mindestens eine Rissführungsschicht vor, wobei die mindestens eine Rissführungsschicht eine von einer ebenen Gestalt abweichende Gestalt aufweist. Diese Lösung ist vorteilhaft, da die erzeugten Festkörperschichten oder die erzeugten Festkörper eine von einer ebenen Schicht abweichende Gestalt aufweisen können. Es können somit nicht mehr nur ebene Schichten, sondern ebenfalls dreidimensionale Körper aus einem Werkstück mittels einer Rissausbreitung herausgebildet bzw. erzeugt werden. Derart hergestellte Festkörper weisen aufgrund des Herstellungsverfahrens eine sehr vorteilhafte und nur wenig bis nicht nachzubearbeitende Oberfläche auf. So sind z.B. optische Elemente, wie z.B. ein Spat oder eine Linse in einem einstufigen oder mehrstufigen, insbesondere zwei oder dreistufigen, Splitprozess herstellbar.

Die Gestalt der Rissführungsschicht weist somit gemäß einer bevorzugten Ausführungsform der vorliegenden Erfindung zumindest abschnittsweise die Kontur eines dreidimensionalen Objektes, insbesondere einer Linse oder eines Spaten, auf.

Gemäß einer weiteren bevorzugten Ausführungsform der vorliegenden Erfindung wird eine Defekterzeugungsvorrichtung, insbesondere eine Ionenkanone oder ein Laser, zum Erzeugen der Defekte verwendet wird.

Gemäß einer bevorzugten Ausführungsform werden Defekten mittels mindestens einer Defekterzeugungsvorrichtung, insbesondere einem Laser, in der inneren Struktur des Werkstücks zum Vorgeben einer Rissführungsschicht, entlang der die Festkörperschicht oder der Festkörper vom Werkstück abgetrennt wird, erzeugt, wobei die Defekte derart voneinander beabstandet erzeugt werden, dass eine bei der jeweiligen Defekterzeugung lokale erfolgende Erhitzung des Werkstück von weiteren bei der Erzeugung weiterer Defekt erfolgender Erhitzungen des Werkstücks entkoppelt ist, wobei bevorzugt jede bei der jeweiligen Defekterzeugung lokale erfolgende Erhitzung des Werkstück von den weiteren bei der Erzeugung weiterer Defekt erfolgender Erhitzungen des Werkstücks entkoppelt ist. Diese Ausführungsform ist vorteilhaft, da die einzelnen lokalen Erhitzungen ungehindert abkühlen können und sich nicht durch nebeneinander erzeugte Defekte eine zusätzlich Erhitzung eines Teils des Werkstücks bewirkt wird, wodurch die Erzeugung hoher lokaler Spannungen verhindert wird.

Ein Beispiel, das nicht unter dem Schutzbereich der Ansprüche fällt umfasst ein Verfahren zum Herstellen von Festkörperschichten oder unebenen Festkörpern das bevorzugt mindestens die nachfolgend genannten Schritte umfasst:
Bereitstellen eines Festkörpers zum Abtrennen mindestens einer Festkörperschicht oder eines unebenen Festkörpers, Erzeugen von Defekten mittels mindestens einer Defekterzeugungsvorrichtung, insbesondere einem Laser, in der inneren Struktur des Werkstücks zum Vorgeben einer Rissführungsschicht, entlang der die Festkörperschicht oder der Festkörper vom Werkstück abgetrennt wird, wobei die Defekte derart voneinander beabstandet erzeugt werden, dass eine bei der jeweiligen Defekterzeugung lokale erfolgende Erhitzung des Werkstück von weiteren bei der Erzeugung weiterer Defekt erfolgender Erhitzungen des Werkstücks entkoppelt ist, wobei bevorzugt jede bei der jeweiligen Defekterzeugung lokale erfolgende Erhitzung des Werkstück von den weiteren bei der Erzeugung weiterer Defekt erfolgender Erhitzungen des Werkstücks entkoppelt ist, Anbringung oder Erzeugung einer Aufnahmeschicht an der exponierten Oberfläche des Werkstücks unter Bildung einer Kompositstruktur, Temperieren der Aufnahmeschicht zum Erzeugen von Spannungen innerhalb des Werkstücks, wobei die Spannungen eine Rissausbreitung innerhalb des Werkstücks bewirken, wobei durch die Rissausbreitung eine Festkörperschicht oder ein Festkörper von dem Werkstück entlang der Rissführungsschicht abgetrennt wird. Diese Lösung ist vorteilhaft, da die einzelnen lokalen Erhitzungen ungehindert abkühlen können und sich nicht durch nebeneinander erzeugte Defekte eine zusätzlich Erhitzung eines Teils des Werkstücks bewirkt wird, wodurch die Erzeugung hoher lokaler Spannungen verhindert wird.

Gemäß einer bevorzugten Ausführungsform der vorliegenden Erfindung werden die Defekte nach einem vorgegebenen Muster erzeugt.

Gemäß einer bevorzugten Ausführungsform der vorliegenden Erfindung wird die Reihenfolge der Defekte von einem Algorithmus erzeugt.

Der Festkörper bzw. das Werkstück weist bevorzugt ein Material oder eine Materialkombination aus einer der Hauptgruppen 3, 4 und 5 des Periodensystems der Elemente auf, wie z.B. Si, SiC, SiGe, Ge, GaAs, InP, GaN, Al2O3 (Saphir), AIN. Besonders bevorzugt weist der Festkörper eine Kombination aus in der dritten und fünften Gruppe des Periodensystems vorkommenden Elementen auf. Denkbare Materialien oder Materialkombinationen sind dabei z.B. Galliumarsenid, Silizium, Siliziumcarbid, etc. Weiterhin kann der Festkörper eine Keramik (z.B. Al2O3 - Alumiumoxid) aufweisen oder aus einer Keramik bestehen, bevorzugte Keramiken sind dabei z.B. Perovskitkeramiken (wie z.B. Pb-, O-, Ti/Zr-haltige Keramiken) im Allgemeinen und Blei-Magnesium-Niobate, Bariumtitanat, Lithiumtitanat, Yttrium-Aluminium-Granat, insbesondere Yttrium-Aluminium-Granat Kristalle für Festkörperlaseranwendungen, SAW-Keramiken (surface acoustic wave), wie z.B. Lithiumniobat, Galliumorthophosphat, Quartz, Calziumtitanat, etc. im Speziellen. Der Festkörper weist somit bevorzugt ein Halbleitermaterial oder ein Keramikmaterial auf bzw. besonders bevorzugt besteht der Festkörper aus mindestens einem Halbleitermaterial oder einem Keramikmaterial. Es ist weiterhin denkbar, dass der Festkörper ein transparentes Material aufweist oder teilweise aus einem transparenten Material, wie z.B. Saphir, besteht bzw. gefertigt ist. Weitere Materialien, die hierbei als Festkörpermaterial alleine oder in Kombination mit einem anderen Material in Frage kommen, sind z.B. "wide band gap"-Materialien, InAlSb, Hochtemperatursupraleiter, insbesondere seltene Erden Cuprate (z.B. YBa2Cu3O7). Es ist zusätzlich oder alternativ denkbar, dass der Festkörper eine Photomaske ist, wobei als Photomaskenmaterial im vorliegenden Fall bevorzugt jedes zum Anmeldetag bekannte Photomaskenmaterial und besonders bevorzugt Kombinationen daraus verwendet werden können.

Weitere Vorteile, Ziele und Eigenschaften der vorliegenden Erfindung werden anhand nachfolgender Beschreibung anliegender Zeichnungen erläutert, in welchen beispielhaft die erfindungsgemäße Waferherstellung dargestellt ist. Bauteile oder Elemente der erfindungsgemäßen Waferherstellung, welche in den Figuren wenigstens im Wesentlichen hinsichtlich ihrer Funktion übereinstimmen, können hierbei mit gleichen Bezugszeichen gekennzeichnet sein, wobei diese Bauteile oder Elemente nicht in allen Figuren beziffert oder erläutert sein müssen.

Einzelne oder alle Darstellungen der im Nachfolgenden beschriebenen Figuren sind bevorzugt als Konstruktionszeichnungen anzusehen, d.h. die sich aus der bzw. den Figuren ergebenden Abmessungen, Proportionen, Funktionszusammenhänge und/oder Anordnungen entsprechen bevorzugt genau oder bevorzugt im Wesentlichen denen der erfindungsgemäßen Vorrichtung bzw. des erfindungsgemäßen Produkts.

Darin zeigt:
- Fig. 1a: einen schematischen Aufbau zum Erzeugen von Lokal-Spannungen in einem Festkörper;
- Fig. 1b: eine schematische Darstellung einer Schichtanordnung vor dem Abtrennen einer Festkörperschicht von einem Festkörper;
- Fig. 1c: eine schematische Darstellung einer Schichtanordnung nach dem Abtrennen einer Festkörperschicht von einem Festkörper;
- Fig. 2a: eine erste schematisch dargestellte Variante zur Erzeugung von Lokal-Spannungen mittels Strahlung, insbesondere Lichtwellen;
- Fig. 2b: eine zweite schematisch dargestellte Variante zur Erzeugung von Lokal-Spannungen mittels Strahlung, insbesondere mittels Lichtwellen;
- Fig. 3a: die Ausnutzung der Eigenschaften einer Immersionsflüssigkeit zum Erzeugung einer Rissführungsschicht zur Erzeugung eines dreidimensionalen Festkörpers;
- Fig. 3b: die Ausnutzung der Eigenschaften einer Immersionsflüssigkeit zum Ausgleichen der Rauigkeit der exponierten Oberfläche des Werkstücks;
- Fig. 4a: eine zusätzliche oder alternative Ausführungsform zum Erzeugen der Defekte in dem Werkstück;
- Fig. 4b: noch eine zusätzliche oder alternative Ausführungsform zum Erzeugen der Defekte in dem Werkstück;
- Fig. 5: eine Darstellung, gemäß der die Festkörperschichten geneigt zu Längsachse des Werkstücks vom Werkstück abgetrennt bzw. abgesplittet werden;
- Fig. 6: die Erzeugung zweier voneinander beabstandeter Defekte, wobei die Defekte durch aus derselben Richtung emittierte Laserstrahlung erzeugt werden.

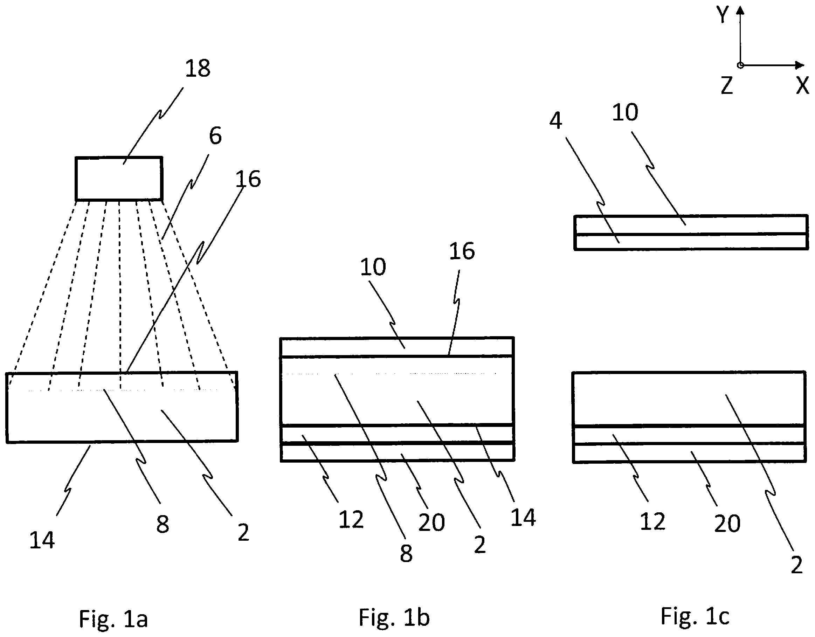

In Fig. 1a ist ein Werkstück 2 bzw. ein Substrat gezeigt, das im Bereich einer Strahlungsquelle 18, insbesondere einem Laser, angeordnet ist. Das Werkstück 2 weist bevorzugt einen ersten, insbesondere ebenen, Flächenanteil 14 und einen zweiten, insbesondere ebenen, Flächenanteil 16 auf, wobei der erste ebene Flächenanteil 14 bevorzugt im Wesentlichen oder genau parallel zu dem zweiten ebenen Flächenanteil 16 ausgerichtet ist. Der erste ebene Flächenanteil 14 und der zweite ebene Flächenanteil 16 begrenzen bevorzugt das Werkstück 2 in einer Y-Richtung, die bevorzugt vertikal bzw. lotrecht ausgerichtet ist. Die ebenen Flächenanteile 14 und 16 erstrecken sich bevorzugt jeweils in einer X-Z-Ebene, wobei die X-Z-Ebene bevorzugt horizontal ausgerichtet ist. Weiterhin lässt sich dieser Darstellung entnehmen, dass die Strahlungsquelle 18 Stahlen 6 zeitgleich oder zeitversetzt auf das Werkstück 2 ausstrahlt. Die Strahlen 6 dringen je nach Konfiguration definiert tief in das Werkstück 2 ein und erzeugen an der jeweiligen Position bzw. an einer vorbestimmten Position Lokal-Spannungen.

In Fig. 1b ist eine mehrschichtige Anordnung gezeigt, wobei das Werkstück 2 die Rissführungsschicht 8 beinhaltet und im Bereich des ersten ebenen Flächenanteils 14 mit einer Halteschicht 12 versehen ist, die wiederum bevorzugt von einer weiteren Schicht 20 überlagert wird, wobei die weitere Schicht 20 bevorzugt eine Stabilisierungseinrichtung, insbesondere eine Metallplatte, ist. An dem zweiten ebenen Flächenanteil 16 des Werkstücks 2 ist bevorzugt eine Polymerschicht 10 angeordnet. Die Aufnahmeschicht bzw. Polymerschicht 10 und/oder die Halteschicht 12 bestehen bevorzugt zumindest teilweise und besonders bevorzugt vollständig aus PDMS.

In Fig. 1c ist ein Zustand nach einer Rissauslösung und anschließender Rissführung gezeigt. Die Festkörperschicht 4 haftet an der Polymerschicht 10 und ist von dem verbleibenden Rest des Werkstücks 2 beabstandet bzw. beabstandbar.

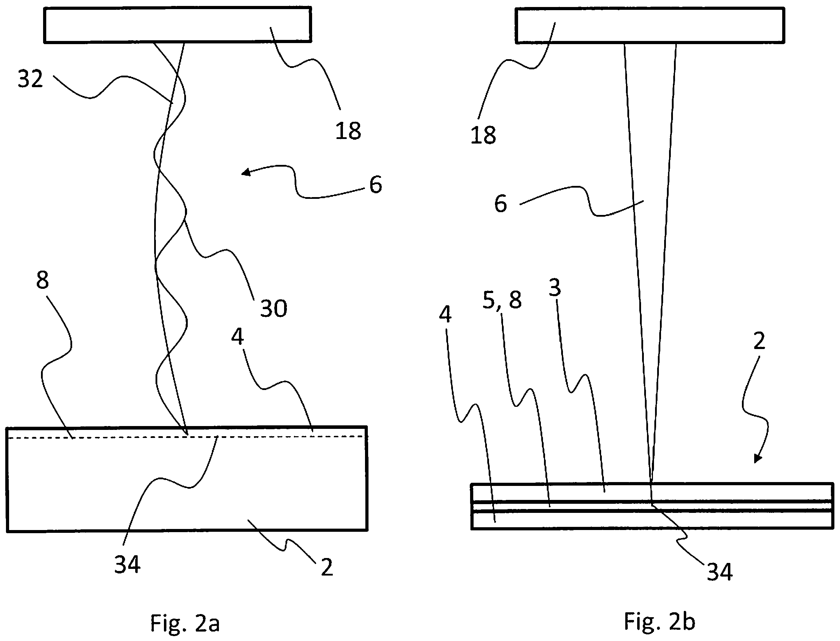

In den Figuren 2a und 2b sind Beispiele für die in Fig. 1a gezeigte Erzeugung einer Rissführungsschicht 8 durch die Einbringung von Lokal-Spannungen in ein Werkstück 2, insbesondere mittels Lichtstrahlen, gezeigt.

Die vorliegende Erfindung bezieht sich somit auf ein Verfahren zum Herstellen von Festkörperschichten. Das erfindungsgemäße Verfahren umfasst dabei mindestens die Schritte des Bereitstellens eines Werkstücks 2 zum Abtrennen mindestens einer Festkörperschicht 4, des Erzeugens von bevorzugt definierten Lokal-Spannungen bzw. von lokalen Spannungen mittels mindestens einer Strahlungsquelle, insbesondere einem Laser, in der inneren Struktur des Festkörpers zum Vorgeben einer Rissführungsschicht, entlang der die Festkörperschicht vom Festkörper abgetrennt wird, und des thermischen Beaufschlagens einer an dem Werkstück 2 angeordneten Polymerschicht 10 zum, insbesondere mechanischen, Erzeugen von Ablöse-Spannungen in dem Werkstück 2, wobei sich durch die Ablöse-Spannungen ein Riss in dem Werkstück 2 entlang der Rissführungsschicht 8 ausbreitet, der die Festkörperschicht 4 von dem Werkstück 2 abtrennt. Diel Lokal-Spannungen bewirken hierbei bevorzugt, dass die Rissausbreitung in der gewünschten Rissführungsschicht 8 erfolgt.

In Fig. 2a ist somit schematisch gezeigt, wie Lokal-Spannungen 34 in einem Werkstück 2, insbesondere zur Erzeugung einer Rissführungsschicht 8 mittels einer Strahlungsquelle 18, insbesondere einem oder mehrerer Laser, erzeugbar sind. Die Strahlungsquelle 18 emittiert dabei Strahlung 6 mit einer ersten Wellenlänge 30 und einer zweiten Wellenlänge 32. Die Wellenlängen 30, 32 sind dabei bevorzugt derart aufeinander abgestimmt bzw. die Distanz zwischen der Strahlungsquelle 18 und der zu erzeugenden Rissführungsschicht 8 ist bevorzugt derart abgestimmt, dass die Wellen 30, 32 im Wesentlichen oder genau auf der Rissführungsschicht 8 in dem Werkstück 2 zusammentreffen, wodurch am Ort des Zusammentreffens 34 infolge der Energien beider Wellen 30, 32 Lokal-Spannungen bzw. Defekte erzeugt werden. Die Erzeugung der Lokal-Spannungen kann dabei durch unterschiedliche oder kombinierte Mechanismen, wie z.B. Sublimation, Aufschmelzen und/oder chemische Reaktion, erfolgen.

In Fig. 2b ist ein fokussierter Lichtstrahl 6 gezeigt, dessen Brennpunkt bevorzugt in der Rissführungsschicht 8 liegt. Es ist hierbei denkbar, dass der Lichtstrahl 6 durch eine oder mehrere fokussierende Körper, insbesondere Linse/n (nichtgezeigt), fokussiert wird. Das Werkstück 2 ist in dieser Ausführungsform mehrschichtig ausgebildet und weist bevorzugt eine teiltransparente oder transparente Substratschicht 3 bzw. Materialschicht auf, die bevorzugt aus Saphir besteht oder Saphir aufweist. Die Lichtstrahlen 6 gelangen durch die Substratschicht 3 auf die Rissführungsschicht 8, die bevorzugt durch eine Opferschicht 5 gebildet wird, wobei die Opferschicht 5 durch die Strahlung derart beaufschlagt wird, dass die Erzeugung von Lokal-Spannungen in der Opferschicht 5 in dem Brennpunkt bzw. im Bereich des Brennpunkts bewirkt wird. Es ist ebenfalls denkbar, dass die Lokal-Spannungen zur Erzeugung der Rissführungsschicht 8 im Bereich oder genau auf einer Grenzfläche zwischen zwei Schichten 3, 4 erzeugt werden. Somit ist ebenfalls denkbar, dass die Festkörperschicht 4 auf einer Trägerschicht, insbesondere einer Substratschicht 3, erzeugt wird und mittels einer oder mehrerer Opferschichten 5 und/oder mittels der Erzeugung von Lokal-Spannungen in einer Grenzfläche, insbesondere zwischen der Festkörperschicht 4 und der Trägerschicht, eine Rissführungsschicht 8 zum Ablösen bzw. Abtrennen der Festkörperschicht 4 erzeugbar ist.

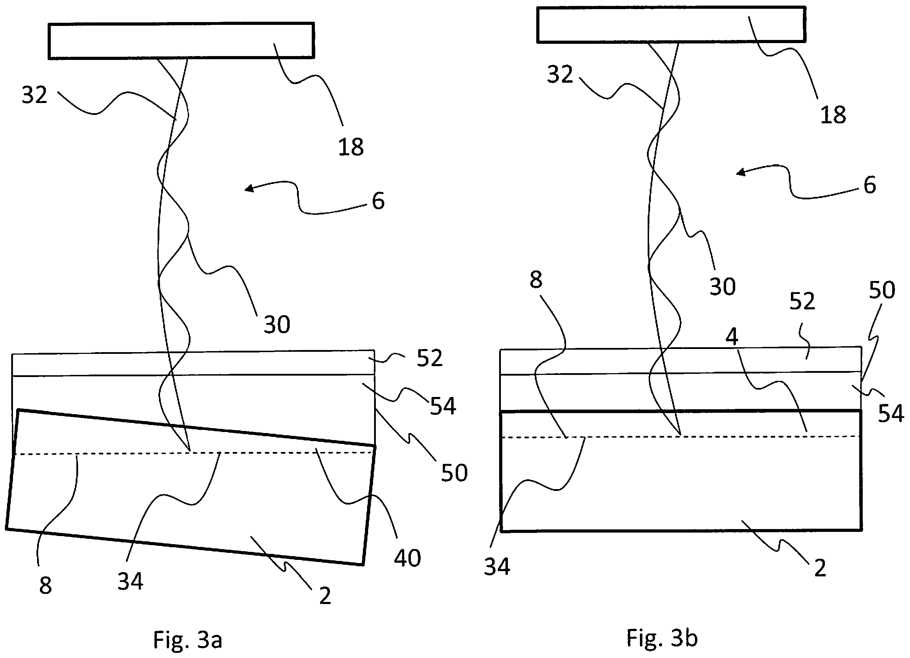

Gemäß Fig. 3a ist eine im Wesentlichen ähnliche Darstellung zu der in Fig. 2a gezeigten Darstellung gezeigt. Gemäß dieser Darstellung wird in einem geneigten Werkstück 2, insbesondere einem Ingot, eine zum Ablösen einer Festkörperschicht bzw. eines unebenen Festkörpers 40 eine Rissführungsschicht 8 erzeugt. Zur präzisen Erzeugung der Rissführungsschicht 8 wird eine Immersionsflüssigkeit 54 bereitgestellt. Die als Tropfen oder, wie dargestellt, als Flüssigkeitsschicht auf der exponierten Oberfläche des Werkstücks 2 aufgebracht wird. Ist die Immersionsflüssigkeit 54 als Flüssigkeitsschicht vorgesehen, dann ist bevorzugt auch eine Wandungseinrichtung 50 zum Ausbilden einer Aufnahmewanne vorgesehen, damit die Flüssigkeit an der gewünschten Position gehalten wird. Weiterhin kann eine Abdeckplatte 52 auf die Flüssigkeit aufgebracht, insbesondere aufgelegt oder eingetaucht, werden. Die Immersionsflüssigkeit 54 weist bevorzugt im Wesentlichen oder genau denselben Brechungsindex, wie das Werkstück 2 auf. Durch die Immersionsflüssigkeit 54 wird bewirkt, dass in dem Weg zwischen der Abdeckplatte 52 und der zu erzeugenden Rissführungsschicht 8 bevorzugt stets der gleiche oder zumindest im Wesentlichen der gleiche Brechungsindex vorliegt, damit die Defekterzeugung möglichst fehlerfrei erfolgen kann.

Gemäß Fig. 3b ist eine Ausführungsform gezeigt, durch welche die Oberflächenrauigkeit des Werkstücks 2 ausgeglichen wird. Die auf der exponierten Oberfläche entweder als Tropfen oder, wie dargestellt, als Flüssigkeitsschicht aufgebrachte Immersionsflüssigkeit 54 bewirkt ebenfalls, dass in dem Weg zwischen der Abdeckplatte 52 und der zu erzeugenden Rissführungsschicht 8 stets der gleiche Brechungsindex vorliegt, damit die Defekterzeugung möglichst fehlerfrei erfolgen kann.

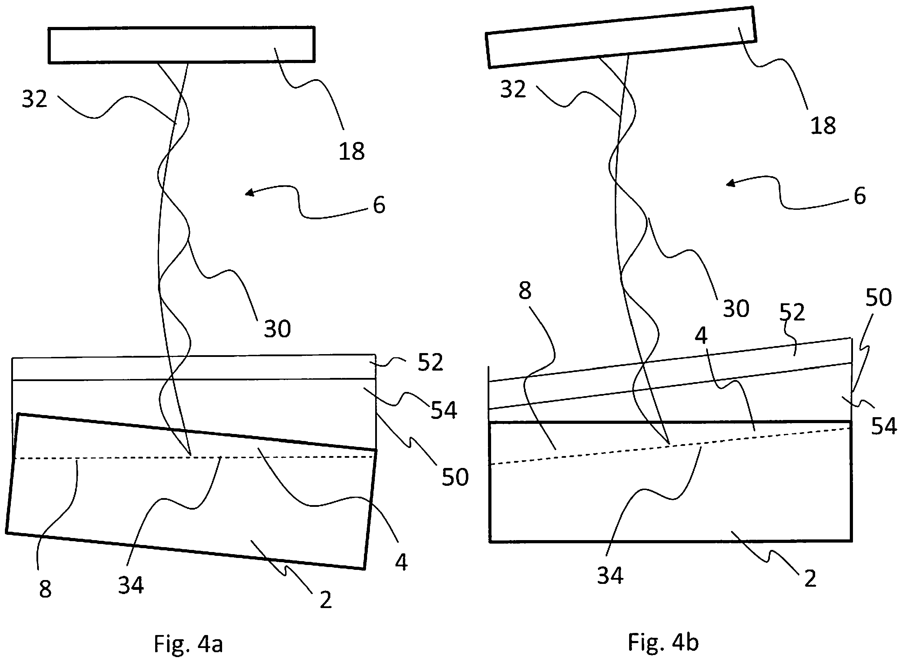

In Fig. 4a ist die aus Fig. 2a bekannte Anordnung in einer modifizierten Form gezeigt. Gemäß dieser Darstellung ist das Werkstück 2 geneigt ausgerichtet. Die geneigte Anordnung ist vorteilhaft, da dadurch die Festkörperschichten 4 entsprechend dem gewachsenen Kristallgitter von dem Werkstück 2 abgetrennt werden können. Ferner ist auf der Oberfläche des Werkstücks 2 bevorzugt eine Immersionsflüssigkeit 54 angeordnet, durch welche die Defekterzeugungsvorrichtung 18 hindurch die Defekte 34 in dem Werkstück 2 zum Ausbilden der Rissführungsschicht 8 erzeugt. Es ist denkbar, dass die Immersionsflüssigkeit 54 als Tropfen, wie dargestellt als Flüssigkeitsschicht, auf der exponierten Oberfläche des Werkstücks 2 aufgebracht wird. Ist die Immersionsflüssigkeit 54 als Flüssigkeitsschicht vorgesehen, dann ist bevorzugt auch eine die Wandungseinrichtung 50 zum Ausbilden einer Aufnahmewanne vorgesehen, damit die Flüssigkeit an der gewünschten Position gehalten wird. Weiterhin kann eine Abdeckplatte 52 auf die Flüssigkeit aufgebracht, insbesondere aufgelegt oder eingetaucht, werden. Die Immersionsflüssigkeit 54 weist bevorzugt im Wesentlichen oder genau denselben Brechungsindex auf, wie das Werkstück 2. Der Brechungsindex der Abdeckplatte kann von dem Brechungsindex der Immersionsflüssigkeit abweichen oder ebenfalls damit übereinstimmen.

In Fig. 4b ist eine alternative Ausführungsform dargestellt. Gemäß dieser Darstellung ist nicht das Werkstück 2, sondern die Defekterzeugungsvorrichtung geneigt angeordnet. Die geneigte Anordnung ist vorteilhaft, da dadurch die zum Abtrennen der Festkörperschichten 4 erforderlichen Rissführungsschicht/en 8 entsprechend dem gewachsenen Kristallgitter des Werkstücks 2 abgetrennt werden können. Weiterhin ist dieser Darstellung zu entnehmen, dass auch die Abdeckplatte 52 geneigt angeordnet ist. Bevorzugt ist die Abdeckplatte 52 stets parallel zu der zu erzeugenden Rissführungsschicht 8 angeordnet.

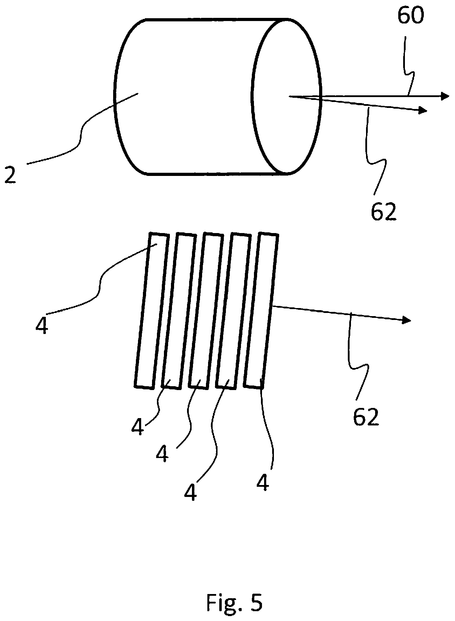

In Fig. 5 ist ein schematisches Werkstück 2 gezeigt. Der Pfeil 60 kennzeichnet dabei ein ideales Kristallgitter und der Pfeil 62 kennzeichnet dabei ein gegenüber dem idealen Kristallgitter um 1° bis mehrere Grad gekipptes Kristallgitter. In Abhängigkeit der Ausgestaltung des Kristallgitters können durch die vorliegende Erfindung die einzelnen Festkörperschichten 4 angepasst vom Werkstück 2 abgetrennt werden.

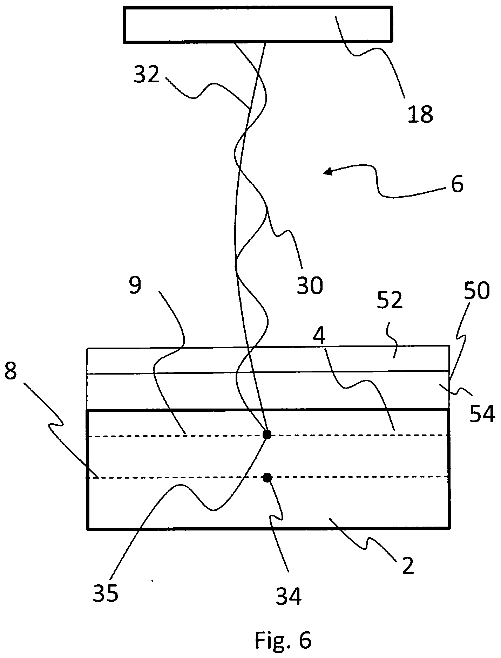

Gemäß Fig. 6 ist eine im Wesentlichen ähnliche Darstellung zu der in Fig. 2a gezeigten Darstellung gezeigt. Gemäß dieser Darstellung erfolgt die Erzeugung zweier voneinander beabstandeter Defekte 34, 35, wobei die Defekte 34, 35 mit Laserstrahlung erzeugt werden, wobei die Laserstrahlung bevorzugt in Richtung derselben sich durch den Raum erstreckenden Geraden erzeugt werden, d.h., dass die Laserstrahlung besonders bevorzugt eine Gerade beschreibt, auf der die Defekte 34, 35 liegen bzw. erzeugt werden. Weiterhin ist jedoch denkbar, dass die Laserstrahlung zur Erzeugung der Defekte 34, 35 auf einer Oberfläche des Werkstücks 2 oder einer Abdeckplatte 52 oder einer Flüssigkeit, insbesondere einer Immersionsflüssigkeit, durch den Brechungsindex des Werkstücks 2 oder der Abdeckplatte 52 oder der Flüssigkeit 54 abgelenkt wird, wobei die Defekte 34, 35 im Verlauf desselben abgelenkten Anteils der Laserstrahlung erzeugt werden. Der Laser, mittels dem die Defekte erzeugt werden, ist bevorzugt ein Neodym-dotierter Yttrium-Aluminium-Granat-Laser. Somit sind besonders bevorzugt bei der Erzeugung von korrespondierenden Defekten 34, 35 auf unterschiedlichen Rissführungsschichten 8, 9 die Orte, an denen die Laserstrahlen aus dem Laser 18 austreten und an denen die Laserstrahlen in das Werkstück 2 eintreten identisch bzw. zumindest im Wesentlichen identisch. Besonders bevorzugt werden das Werkstück 2 und der Laser 18 zunächst relativ zueinander ausgerichtet. In einem weiteren Schritt wird bevorzugt ein Defekt 34, der auf der ersten Rissführungsebene 8 liegt, und unmittelbar danach der zweite Defekt 35, der auf der zweiten Rissführungsschicht 9 liegt erzeugt, wobei durch die Defekte die einzelnen Rissführungsebenen 8, 9 gebildet werden. Es ist hierbei jedoch ebenfalls denkbar, dass mehr als zwei Defekte 34, 35 erzeugt werden, je nachdem, wie viele Rissführungsschichten vorgesehen sind. Nach der Erzeugung der korrespondierenden Defekte 34, 35 werden das Werkstücks 2 und der Laser 18 zum Erzeugen weiterer korrespondierender Defekte neu relativ zueinander positioniert.

Zur präzisen Erzeugung der Rissführungsschicht 8 wird bevorzugt eine Immersionsflüssigkeit 54 bereitgestellt. Die als Tropfen oder, wie dargestellt, als Flüssigkeitsschicht auf der exponierten Oberfläche des Werkstücks 2 aufgebracht wird. Ist die Immersionsflüssigkeit 54 als Flüssigkeitsschicht vorgesehen, dann ist bevorzugt auch eine Wandungseinrichtung 50 zum Ausbilden einer Aufnahmewanne vorgesehen, damit die Flüssigkeit an der gewünschten Position gehalten wird. Weiterhin kann eine Abdeckplatte 52 auf die Flüssigkeit aufgebracht, insbesondere aufgelegt oder eingetaucht, werden. Die Immersionsflüssigkeit 54 weist bevorzugt im Wesentlichen oder genau denselben Brechungsindex auf, wie das Werkstück 2. Durch die Immersionsflüssigkeit 54 wird bevorzugt bewirkt, dass in dem Weg zwischen der Abdeckplatte 52 und der zu erzeugenden Rissführungsschicht 8 stets der gleiche bzw. zumindest im Wesentlichen gleiche Brechungsindex vorliegt, damit die Defekterzeugung möglichst fehlerfrei erfolgen kann.

### Bezugszeichenliste

- 2: Werkstück
- 3: Substrat
- 4: Festkörperschicht
- 5: Opferschicht
- 6: Strahlung
- 8: Rissführungsschicht
- 10: Polymerschicht/Aufnahmeschicht
- 12: Halteschicht
- 14: erster ebener Flächenanteil
- 16: zweiter ebener Flächenanteil
- 18: Strahlungsquelle/Defekterzeugungsvorrichtung
- 20: Stabilisierungseinrichtung
- 30: erster Strahlungsanteil
- 32: zweiter Strahlungsanteil
- 34: Ort der Erzeugung von Lokal-Spannungen
- 40: Festkörper
- 50: Wandung
- 52: Abdeckplatte
- 54: Immersionsflüssigkeit

- X: erste Richtung
- Y: zweite Richtung
- Z: dritte Richtung

## Patentansprüche

1. Verfahren zur Herstellung von Festkörperschichten (4) und/oder unebener Festkörper (40) mit den folgenden Schritten:
Bereitstellen eines Werkstücks (2) zum Ablösen mindestens einer Festkörperschicht (4) und/oder mindestens eines Festkörpers (40),
wobei das Werkstück (2) zumindest eine exponierte Oberfläche aufweist,
Aufbringen einer Immersionsflüssigkeit (54) auf die exponierte Oberfläche,
Erzeugen von Defekten (34) innerhalb des Werkstücks (2),
wobei die Defekte (34) mindestens eine Rissführungsschicht (8) vorgeben,
wobei zur Erzeugung der Defekte (34) eine Beaufschlagung des Werkstücks (2) mittels einer Defekterzeugungsvorrichtung (18)
durch die Immersionsflüssigkeit (54) hindurch erfolgt,
Entfernen der Immersionsflüssigkeit (54) von der exponierten Oberfläche,
Anbringung oder Erzeugung einer Aufnahmeschicht (10) an der exponierten Oberfläche des Werkstücks (2) unter Bildung einer Kompositstruktur,
Temperieren der Aufnahmeschicht (10) zum Erzeugen von Spannungen innerhalb des Werkstücks (2), wobei die Spannungen eine Rissausbreitung innerhalb des Werkstücks (2) bewirken, wobei durch die Rissausbreitung eine Festkörperschicht (4) oder ein Festkörper (40) von dem Werkstück (2) entlang der Rissführungsschicht (8) abgetrennt wird, wobei
die Immersionsflüssigkeit (54) in einer solchen Menge auf der exponierten Oberfläche aufgebracht wird, dass durch sie zumindest mehr als die Hälfte der exponierten Oberfläche benetzt wird, und die Immersionsflüssigkeit (54) mit einer Abdeckplatte (52) derart abgedeckt wird, dass zwischen der zu erzeugenden Rissführungsschicht (8) und der Abdeckplatte (52) zumindest im Wesentlichen derselbe Brechungsindex vorliegt, wobei die Oberfläche der Abdeckplatte (52), die mit der Immersionsflüssigkeit (54) in Kontakt ist,
und die exponierte Oberfläche des Werkstücks (2) derart geneigt zueinander ausgerichtet sind, dass der Anteil der Immersionsflüssigkeit (54) zwischen der Abdeckplatte (52) und der exponierten Oberfläche in Abhängigkeit von Ort variiert.

2. Verfahren nach Anspruch 1,
**dadurch gekennzeichnet, dass**
der Brechungsindex der Immersionsflüssigkeit (54) mit dem Brechungsindex des Werkstücks (2) zumindest im Wesentlichen übereinstimmt.

3. Verfahren nach Anspruch 1 oder Anspruch 2
**dadurch gekennzeichnet, dass**
die Abdeckplatte (52) zumindest auf der von der exponierten Oberfläche des Werkstücks (2) abgewandten Seite eine Oberflächenrauheit aufweist, die geringer ist als die Oberflächenrauheit der exponierten Oberfläche.

## Claims

1. A method for producing solid layers (4) and/or uneven solids (40) comprising the following steps:
providing a workpiece (2) for the detachment of at least one solid layer (4) and/or at least one solid (40),
wherein the workpiece (2) comprises at least one exposed surface,
applying an immersion liquid (54) on the exposed surface,
generating defects (34) inside the workpiece (2),
wherein the defects (34) define at least one crack-conducting layer (8),
wherein, to generate the defects (34), the workpiece (2) is acted upon by means of a defect-generating device (18) through the immersion liquid (54),
removing the immersion liquid (54) from the exposed surface,
applying or generating a receiving layer (10) on the exposed surface of the workpiece (2) thereby forming a composite structure,
tempering the receiving layer (10) to generate stresses inside the workpiece (2), wherein the stresses give rise to a crack propagation inside the workpiece (2), wherein, as a result of the crack propagation, a solid layer (4) or a solid (40) is separated from the workpiece (2) along the crack-conducting layer (8),
wherein the immersion liquid (54) is applied on the exposed surface in a quantity which is such that at least over half the exposed surface is wetted by it, and the immersion liquid (54) is covered with a cover plate (52) in such a way that at least essentially the same refractive index is present between the crack-conducting layer (8) to be generated and the cover plate (52), wherein
the surface of the cover plate (52) that is in contact with the immersion liquid (54) and the exposed surface of the workpiece (2) are orientated inclined with respect to one another, in such a way that the proportion of the immersion liquid (54) between the cover plate (52) and the exposed surface varies depending on location.

2. The method according to claim 1,
**characterised in that**
the refractive index of the immersion liquid (54) at least essentially corresponds to the refractive index of the workpiece (2).

3. The method according to claim 1 or 2,
**characterised in that**,
at least on the side facing away from the exposed surface of the workpiece (2), the cover plate (52) has a surface roughness which is less than the surface roughness of the exposed surface.

## Revendications

1. Procédé de fabrication de couches (4) de corps solides et/ou de corps solides (40) non plans, comportant les étapes suivantes :
de la mise à disposition d'une pièce d'oeuvre (2) pour détacher au moins une couche (4) de corps solide et/ou au moins un corps solide (40),
la pièce d'oeuvre (2) comportant au moins une surface exposée,
de l'application d'un liquide d'immersion (54) sur la surface exposée,
de la création de défauts (34) à l'intérieur de la pièce d'oeuvre (2),
les défauts (34) prédéfinissant au moins une couche de guidage des fissures (8),
lors duquel pour créer les défauts (34), il s'effectue un passage de la pièce d'oeuvre (2) à l'aide d'un dispositif de création de défauts (18) à travers le liquide d'immersion (54),
du retrait du liquide d'immersion (54) de la surface exposée,
de l'application ou de la création d'une couche de réception (10) sur la surface exposée de la pièce d'oeuvre (2), en formant une structure composite,
de la mise en température de la couche de réception (10) pour créer des tensions à l'intérieur de la pièce d'oeuvre (2), les tensions provoquant une propagation des fissures à l'intérieur de la pièce d'oeuvre (2), suite à la propagation des fissures, une couche (4) de corps solide ou un corps solide (40) se sectionnant de la pièce d'oeuvre (2), le long de la couche de guidage des fissures (8),
lors duquel on applique le liquide d'immersion (54) sur la surface exposée dans une quantité telle qu'elle humecte au moins plus de la moitié de la surface exposée et on recouvre le liquide d'immersion (54) avec une plaque de recouvrement (52) de telle sorte qu'entre la couche de guidage des fissures (8) qui doit être créée et la plaque de recouvrement (52), au moins sensiblement le même indice de réfraction soit présent,
la surface de la plaque de recouvrement (52) qui est en contact avec le liquide d'immersion (54) et la surface exposée de la pièce d'oeuvre (2) étant orientées en étant inclinées l'une vers l'autre de telle sorte que la part du liquide d'immersion (54) entre la plaque de recouvrement (52) et la surface exposée varie en fonction de l'endroit.

2. Procédé selon la revendication 1,
**caractérisé en ce que**
l'indice de réfraction du liquide d'immersion (54) correspond au moins sensiblement à l'indice de réfraction de la pièce d'oeuvre (2).

3. Procédé selon la revendication 1 ou 2,
**caractérisé en ce**
**qu'**au moins sur le côté opposé à la surface exposée de la pièce d'oeuvre (2), la plaque de recouvrement (52) présente une rugosité superficielle qui est inférieure à la rugosité superficielle de la surface exposée.
